(19) **Europäisches Patentamt / European Patent Office / Office européen des brevets**

(11) **EP 3 657 192 B1**

(12) **EUROPEAN PATENT SPECIFICATION**

(45) Date of publication and mention of the grant of the patent:
**04.10.2023   Bulletin 2023/40**

(21) Application number: **18834783.5**

(22) Date of filing: **22.05.2018**

(51) International Patent Classification (IPC):
**G01R 33/06** (2006.01)

(52) Cooperative Patent Classification (CPC):
**G01R 33/06;** G01R 33/063

(86) International application number:
**PCT/JP2018/019705**

(87) International publication number:
**WO 2019/017066 (24.01.2019 Gazette 2019/04)**

(54) **ULTRA-SMALL HIGH-SENSITIVITY MAGNETIC SENSOR**

ULTRAKLEINER HOCHSENSITIVER MAGNETSENSOR

CAPTEUR MAGNÉTIQUE ULTRA-PETIT À HAUTE SENSIBILITÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **21.07.2017   JP 2017141410**

(43) Date of publication of application:
**27.05.2020   Bulletin 2020/22**

(73) Proprietor: **ASAHI INTECC CO., LTD.**
**Seto-shi, Aichi 489-0071 (JP)**

(72) Inventors:
• **HONKURA, Yoshinobu**
**Chita-gun**
**Aichi 470-2102 (JP)**
• **HONKURA, Shinpei**
**Chita-gun**
**Aichi 470-2102 (JP)**
• **KUDO, Kazue**
**Nagoya-shi**
**Aichi 454-0831 (JP)**
• **TANABE, Junichi**
**Nagoya-shi**
**Aichi 454-0818 (JP)**
• **KIKUCHI, Eiki**
**Tokai-shi**
**Aichi 476-0003 (JP)**

(74) Representative: **Winter, Brandl - Partnerschaft mbB**
**Alois-Steinecker-Straße 22**
**85354 Freising (DE)**

(56) References cited:
EP-A1- 2 813 859     JP-A- H03 156 391
JP-A- 2003 167 037     JP-A- 2005 147 998
JP-A- 2009 503 443     JP-A- 2014 153 309
JP-B1- 5 839 527     JP-B1- 6 256 962
JP-B2- 4 529 783     US-A1- 2006 202 291
US-A1- 2014 247 042     US-A1- 2016 238 673
US-B1- 9 577 185

## Description

### Technical Field

The present invention relates to a technology of achieving ultra-small size and thickness of a GSR sensor by integrally forming a GSR element and an application specific integrated circuit (hereinafter, referred to as an ASIC).

Here, the GSR sensor refers to a high-sensitivity micro magnetic sensor based on the GHz Spin Rotation effect.

### Background Art

As high-sensitivity micro magnetic sensors, there are horizontal type FG sensors, vertical type FG sensors, hall sensors, GMR sensors, TMR sensors, MI sensors, GSR sensors, high frequency carrier sensors, and the like. Nowadays, these sensors have been widely adopted in smartphones, automobiles, medical care, robots, and the like. Among them, the GSR sensors (Patent Literature 1) are excellent in sensitivity and size, and attract the most attention.

Nowadays, studies (Patent Literatures 2 and 3) have been advanced for mounting a magnetic sensor in an in-vivo motion device such as a catheter and obtaining position and orientation to achieve remote control treatment utilizing the measurement values.

For mounting in an in-vivo motion device, a sensor size is preferably as small as possible. However, detection sensitivity decreases in inverse proportion to the sensor size, and therefore, downsizing while maintaining required detection sensitivity is difficult. For example, for a case of mounting in a catheter, development of a magnetic sensor having ultra-small size of width of about 0.1 mm, length of about 0.3 mm, and thickness of about 0.05 mm, and excellent ultra-high sensitivity in magnetic field detection ability of about 0.1 mG to 1 mG has been expected.

### Citation List

#### Patent Literature

Patent Literature 1: Japanese Patent No. 583975
Patent Literature 2: Japanese Patent Application Publication No. 2015-134166
Patent Literature 3: Japanese Patent Application Publication No. 2017-12840
Patent Literature 4: Japanese Patent Application Publication No. 2014-153309
Patent Literature 5: Japanese Patent Application Publication No. 2014-042055
Patent Literature 6: US 2016/0238673 A1
Patent Literature 7: US 2014/0247042 A1

### Summary of Invention

#### Technical Problem

For downsizing GSR sensors, multilateral attempts for downsizing of GSR elements, downsizing of ASICs, and a jointing method of both the GSR elements and the ASICs (Patent Literature 4) have been performed. On the other hand, studies on the effect of the permeability and the diameter of the wire, the numbers of the coil turns and the pulse frequency and current strength of the exciting pulse using micro coils have been investigated (Patent Literature 6). As further, the design of the bridge type magnetic field sensor, in particular a three-axis magnetic field sensor has been suggested (Patent Literature 7). However, all of the attempts have a limitation in downsizing, in particular, thickness reduction, since an element and an ASIC are manufactured separately as two components and then jointed to each other (Patent Literatures 4 and 5).

#### Solution to Problem

This object is solved by the subject matter of the independent claim. Further aspects are disclosed in the subclaims.

As a result of intensive studies for jointing of an ASIC and a GSR element, the present inventors have found that the thickness can be reduced by forming a film serving as a substrate of a GSR element on an insulating protective film of an ASIC main body, attaching a groove in which a magnetic wire is arrayed onto the substrate film, and integrally forming the GSR element including the magnetic wire and a detection coil wound around the magnetic wire.

The present inventors have found that as the substrate film of the GSR element, an oxide such as $SiO_2$ or $Al_2O_3$, or a nitride such as SiN can be used.

That is, when such a substrate film is used, in a case of forming a GSR element directly on a ASIC surface, there are processes of processing of a micro groove, $CF_4$ gas plasma processing, resist heating cure processing, or developing processing using acidity or alkalinity that are included in a manufacturing process of the GSR element, and damage in the insulating protective film of the ASIC surface, function reduction of an ASIC circuit under the GSR element substrate due to the damage, or the like was not recognized.

Moreover, the present inventors have found that a single structure can be used, in which the insulating protective film is formed to be thick, and the element is formed on the insulating protective film.

The present inventors have found that the area of the entire GSR element can be reduced by adopting through hole type jointing of passing through the substrate film and the insulating protective film for jointing of the ASIC and the GSR element and making the size of an electrode small.

Advantageous Effects of Invention

According to the present invention, a GSR sensor can be made thin and ultra-small.

Brief Description of Drawings

Fig. 1 is a plan view of a GSR sensor and a GSR element in an embodiment and an example.

Fig. 2 is a cross-sectional view taken along the line A1-A2 in Fig. 1.

Fig. 3 is a cross-sectional view taken along the line B1-B2 in Fig. 1.

Fig. 4 is a view of an electronic circuit in the embodiment and the example.

Fig. 5 is a diagram of the relationship between passage of energizing time and application of a pulse current at the time of energizing of an element with a pulse current.

Description of Embodiments

An embodiment of the present invention is defined in appended claim 1 and comprises, inter alia, the following features:

An ultra-small and high-sensitive magnetic sensor of the present invention includes: an ASIC; an insulating protective film formed on a wiring plain surface of the ASIC; a substrate film formed on the protective film; and a magnetic field detection element formed on the substrate film, in which the magnetic field detection element includes a magnetic wire, a detection coil wound around the magnetic wire, and an electrode on the substrate film

The magnetic wire has conductivity and an anisotropic magnetic field of 20 G or smaller, and has a two-phase magnetic domain structure of a surface magnetic domain having spin alignment in a circumferential direction, and a central core magnetic domain having spin alignment in an axial direction. The detection coil has a coil pitch of 10 $\mu$m or smaller

The electrode is directly jointed by a through hole type to an element coupling electrode of the ASIC by passing through the substrate film and the insulating protective film

According to the present invention, a film having a thickness capable of functioning as a substrate of a magnetic field detection element is formed on an insulating protective film of an ASIC surface, and the film is used as a substrate. A groove is attached to the substrate film, and a magnetic wire is arrayed in a groove to manufacture a magnetic field detection element. That is, a sensor including the magnetic field detection element integrally formed with the ASIC can be made thin and ultra-small size thereof can be achieved.

The ASIC of the ultra-small and high-sensitivity magnetic sensor of the present invention includes: a means that causes a pulse current of reduced frequency of 0.2 GHz to 4.0 GHz to flow in a magnetic wire of the magnetic field detection element; a means that detects a coil voltage generated when the pulse current flows in the magnetic wire; and a means that converts the coil voltage into an electric signal proportional to an external magnetic field H. Note that the high sensitivity is achieved by causing the pulse current of 0 2 to 40 GHz to flow

The thickness of the substrate film of the ultra-small and high-sensitivity magnetic sensor of the present invention is 1 $\mu$m to 20 $\mu$m.

According to the present invention, the substrate film is required to have the thickness for the extent that a groove accommodating the magnetic wire can be attached. Assumed diameter of the magnetic wire is 1 $\mu$m to 10 $\mu$m. When the substrate film is too thick, a problem arises in adhesiveness with the insulating protective film. Accordingly, the thickness of the substrate film is preferably 1 $\mu$m to 20 $\mu$m. When enough thickness of the insulating protective film for having a function as a substrate is secured, a single layer structure in which the insulating protective film also serves as a substrate film can be adopted.

In the ultra-small and high-sensitivity magnetic sensor of the present invention, in the magnetic field detection element, a groove of depth of 1 $\mu$m to 10 $\mu$m from the upper surface of the substrate film is arranged, and a part or all of the detection coil is embedded.

According to the present invention, the magnetic field detection element can be downsized.

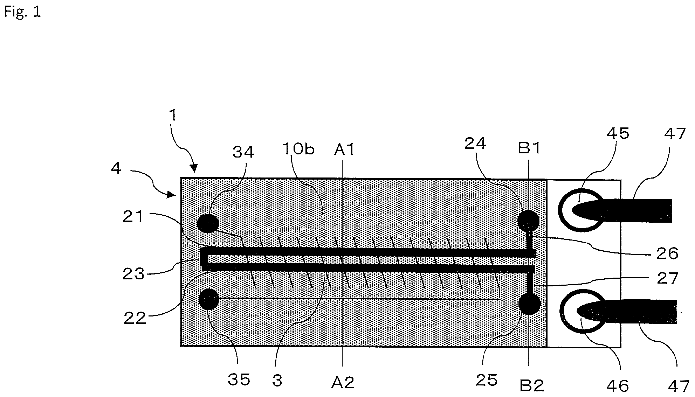

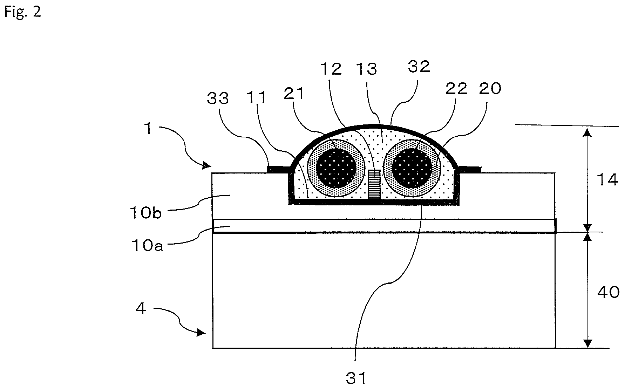

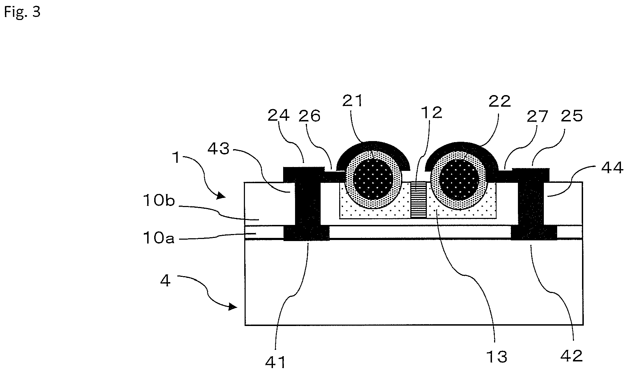

Embodiments of the present invention will be described in detail below with reference to Fig. 1 showing a plan view of a GSR sensor and a GSR sensor element (hereinafter, referred to as an element), Fig. 2 showing a cross-sectional view taken along the line A1-A2, and Fig. 3 showing a cross-sectional view taken along the line B1-B2 of the plan view.

In the present invention, an embodiment in which there are two magnetic wires, and two layers of the insulating protective film and the substrate film will be described are included.

The ultra-small and high-sensitivity magnetic sensor (hereinafter, referred to as a sensor) of the present invention includes: a GSR sensor element 1 (hereinafter, referred to as an element); an ASIC 4; and electrodes (45 and 46) for external wiring from the ASIC 4.

<Sensor>

The element 1 included in the sensor includes: two magnetic wires 2 (21 and 22) on a substrate film 10b formed on an insulating protective film 10a of the ASIC 4; a coil 3 wound around the magnetic wires; two electrodes (24 and 25) for energizing the wires; two electrodes (34 and 35) for coil voltage detection; connection parts (26 and 27) between the magnetic wires and the electrodes for energizing the wires; a connection part between the coil and an electrode for coil detection; a joint part of a through hole type between a coil electrode in the element side and a coil electrode in the ASIC side; and a joint part of a through hole type between a wire electrode in the element side and a wire electrode in the ASIC side (43 and 44).

Furthermore, the element 1 includes a wire coupling part 23 as a means that causes an opposite pulse current to flow in the two magnetic wires.

The ASIC 4 includes an electronic circuit in which each of two coil electrodes and two wire electrodes is connected with the element 1 by an electrode joint part of the through hole type, and when a pulse current flows in the element, a coil voltage generated in the detection coil is detected, and the coil voltage is converted to an external magnetic field. In the ASIC, electrodes (45 and 46) for external wiring are arranged.

Here, a method of determining the external magnetic field from the detected coil voltage in the GSR sensor will be described.

An external magnetic field H and a coil voltage Vs are represented by the mathematical relationship as the formula (1) below, and the coil voltage is converted to the external magnetic field H using the formula.

$$Vs = V_0 \cdot 2L \cdot \pi D \cdot p \cdot Nc \cdot f \cdot \sin\left(\pi H / 2Hm\right) \quad (1)$$

Here, Vs represents an coil output voltage, $V_0$ represents a proportional constant, L represents a wire length, D represents a wire diameter, p represents a skin depth of a pulse current, Nc represents the number of turns of a coil, f represents a pulse frequency, and Hm is an external magnetic field strength when the coil output voltage is the maximum value.

<Structure of Element>

The structure of the element 1 is as shown in Figs. 1 to 3.

The element 1 has the size of width of 0.07 mm to 0.4 mm, and length of 0.25 mm to 1 mm that is the size of the substrate 10. The thickness is 10 $\mu$m to 15 $\mu$m. Accordingly, since the thickness of the ASIC 4 is 30 $\mu$m to 100 $\mu$m, the thickness of the sensor is 40 $\mu$m to 115 $\mu$m.

In the central portion of the element 1, a groove 11 having the width of 20 $\mu$m to 60 $\mu$m and the depth of 1 $\mu$m to 10 $\mu$m is formed in the substrate film 10b so that the two magnetic wires (21 and 22) can be arrayed and arranged in parallel. The two magnetic wires (21 and 22) are close to each other, and the interval between the two magnetic wires is 1 $\mu$m to 10 $\mu$m. A magnetic wire 21 and a magnetic wire 22 are isolated by an insulating material, and the isolating is preferably performed by an insulating separation wall 12, for example.

<Magnetic Wire>

The magnetic wire 2 has a diameter of 1 $\mu$m to 10 $\mu$m made of a CoFeSiB alloy. The periphery of the magnetic wire 2 is preferably covered by an insulating material, for example, an insulating glass material. The length is 0.07 mm to 1 mm.

The anisotropic magnetic field of the magnetic wire 2 is 20 G or smaller, and the magnetic wire 2 has a two-phase magnetic domain structure of a surface magnetic domain having spin alignment in a circumferential direction, and a central core magnetic domain having spin alignment in an axial direction.

<Coil>

The number of turns of the coil 3 is 6 to 180, and the coil pitch of the coil 3 is 0.2 $\mu$m 10 $\mu$m. The interval between the coil 3 and the magnetic wire 2 is 0.2 $\mu$m to 3 $\mu$m. The average inner diameter of the coil is 2 $\mu$m to 35 $\mu$m.

<Manufacturing Method of Element>

The thickness from the ASIC surface to the element part 1 can be made to be 20 $\mu$m or smaller by forming the substrate film 10b on the insulating protective film 10a on the surface of the ASIC, attaching a groove of depth of 1 $\mu$m to 10 $\mu$m to the substrate film 10b, and forming an element such that a part or all of the coil is embedded along the groove surface. By forming the thickness of the ASIC to be about 30 $\mu$m, the thickness of the entire sensor can be made to be about 50 $\mu$m.

The element 1 can be formed by forming the substrate film 10b on the insulating protective film 10a of the upper surface of the ASIC. Two-layer film of the insulating protective film and the substrate film is formed. However, the film may be one-layer film as long as the thickness is enough for the insulating protective film having a function as a substrate. As an example of the two-layer film, an $SiO_2$ (silicon dioxide) film having the thickness of 0.5 $\mu$m to 2 $\mu$m is formed on the ASIC surface by the vacuum deposition method or the like, and an SiN (silicon nitride) film having the thickness of 1 $\mu$m to 10 $\mu$m is further formed on the upper surface of the $SiO_2$ film. A groove having the depth of 1 $\mu$m to 10 $\mu$m is attached to the SiN film, and an element is formed such that a part or all of the coil is embedded along the groove surface.

Electrode wiring is performed on a lower coil 31 and the substrate film surface along the groove 11 formed in the substrate film 10b. Thereafter, an insulating separation wall 12 is formed in the central portion of the groove 11 to form two-groove shape, and two magnetic wires (21 and 22) covered with glass are arrayed and arranged in the groove shapes, respectively.

Next insulating resin coating is performed on the entire surface of the substrate film. In this way, the magnetic wires (21 and 22) are fixed into the groove 11. At the time of this coating, coating is made thin in the upper portion of the magnetic wires (21 and 22). An upper coil 32 is formed thereon by the photolithography technology.

Here, as the characteristics of the substrate film and the insulating protective film, resistance in the processes such as micro groove processing, CF4 gas plasma processing, resist heating cure processing, development processing using acidity or alkalinity, and the like in the manufacturing process of the element 1, and prevention of the function reduction of the ASIC circuit are required. Accordingly, as long as the characteristics required here are achieved, the material of the substrate film is not limited to oxide or nitride.

Note that when the magnetic wire 2 not covered with glass is used, insulating material coating is performed in advance so that the lower coil 31 does not electrically contact with the magnetic wires (21 and 22).

In the manufacturing of the coil, the lower coil 31 having the concaved shape is formed along the groove surface of the groove 11 and both sides of the groove 11 formed on the substrate film 10b. The upper coil 32 having the convex shape is electrically jointed to the lower coil 31 via a joint part 33 so that a spiral-shape coil 3 is formed.

End portions of the two magnetic wires (21 and 22) are made to be able to perform electrical connection by metal deposition by removing the glass of the insulating coating material

<Wiring Structures of Magnetic Wire and Coil>

Wiring structures of the magnetic wire 2 and the coil 3 will be described with reference to Fig. 1.

In the wiring structure of the magnetic wire 2, a wire input electrode (+) is connected to the upper magnetic wire 21 and is connected to the lower magnetic wire 22 via the wire coupling part 23. The lower magnetic wire 22 is connected to a wire output electrode (-) 25.

By this wire coupling part, a pulse current in the left direction from right to left can flow in the magnetic wire 21, and a pulse current in the right direction (opposite direction as the magnetic wire 21) from left to right can flow in the magnetic wire 22.

In the wiring structure of the coil 3, a coil output electrode (+) 34 is connected to an upper end portion of the coil 3, and a coil ground electrode (-) is connected to a lower end portion of the coil 3.

The electrode in the element side and the electrode in the ASIC side are electrically connected with each other via joint parts (43 and 44) of the through hole type passing through the insulating protective film 10a and the substrate film 10b as shown in the example of Fig. 3.

Fig. 3 shows that the magnetic wire input electrode (+) 24 is connected to the wire electrode (+) 41 in the ASIC side via the electrode joint part (+) 43 of the through hole type passing through the insulating protective film 10a and the substrate film 10b, and the magnetic wire output electrode (-) 25 in the element side is connected to the wire electrode (-) 42 in the ASIC side via the electrode joint part (-) 44 of the through hole type passing through the insulating protective film 10a and the substrate film 10b.

Similarly, the coil electrode in the element side and the coil electrode in the ASIC side are connected with each other via the electrode joint part passing through the insulating protective film 10a and the substrate film 10b.

<Electronic Circuit>

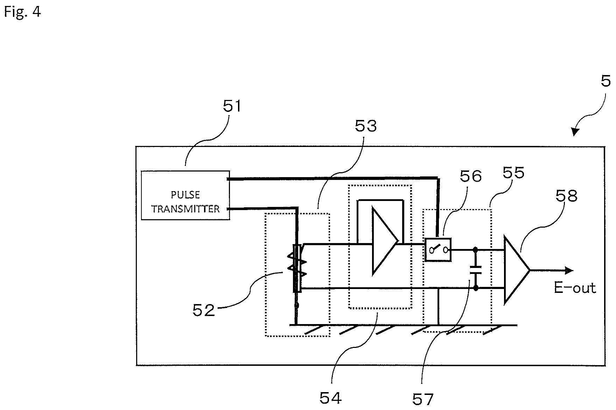

For the electronic circuit 5, reference is made to the pulse-responsive buffer circuit disclosed in Patent Literature 1, and Fig. 4 shows the electronic circuit 5.

The electronic circuit 5 is connected with an element 52 that outputs the coil voltage. AD conversion is performed by amplifying in a pulse oscillation circuit 51 that sends a pulse current to the element 52, an input circuit 53 that inputs the coil voltage, a pulse-responsive buffer circuit 54, a sample hold circuit 55 including an electronic switch 56 that detects the peak voltage of the rising pulse output waveform of the coil and a capacitor 57 of a capacity of 4pF to 100 pF that holds the peak voltage, and a programming amplifier of an amplifier 58. A signal is transferred to an external signal processing device by two wires.

AD conversion is performed by 14 bits to 16 bits. For finely performing on-off an electronic switch, the capacitor capacity is preferably 4 pF to 8 pF.

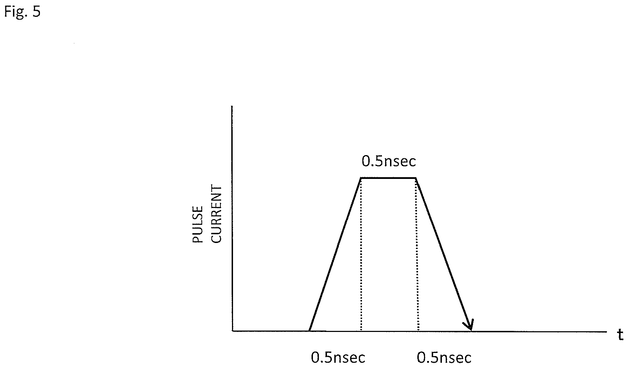

The reduced frequency of the pulse current is 0.2 GHz to 4 GHz, the intensity of the pulse current is 50 mA to 200 mA, and the pulse energizing time of 2 nsec or less. Fig. 5 shows the relationship between passage of energizing time and application of a pulse current at the time of energizing of an element with a pulse current. In the example of Fig. 5, the pulse current rises in 0.5 nsec, remains in the application state for a predetermined pulse time of 0.5 nsec, and rises in 0.5 nsec.

The coil output is in the measurement range of 3 G to 100 G by sine wave output, and the sensitivity thereof is 50 mV/G to 3 V/G The linearity of the coil output is equal to or less than 0.3%.

Example

An example of the present invention will be described with reference to Fig. 1 showing a plan view of a GSR sensor and a GSR element according to an example, Fig. 2 showing a cross-sectional view taken along the line A1-A2, and Fig. 3 showing a cross-sectional view taken along the line B1-B2 of the plan view.

Here, the configuration of the GSR sensor and the configuration of the element, and the electronic circuit are according to the embodiments described above.

The element 1 has the size of the width of 0.10 mm and the length of 0.40 mm. A thickness 40 of the ASIC 4 is 50 $\mu$m, a thickness 14 of the insulating protective film 10a and the substrate film 10b is 8 $\mu$m, the thickness of the convex portion of the element is 2 $\mu$m, and the thickness of the sensor obtained by summing these is 60 $\mu$m. In the central portion of the element 1, the groove 11 of the width of 20 $\mu$m and the depth of 3 $\mu$m is formed in the substrate film 10b such that the two magnetic wires (21 and 22) can be arrayed and arranged in parallel. The two magnetic wires (21 and 22) are close to each other, the interval of the magnetic wires is 3 $\mu$m, and the magnetic wires (21 and 22) are isolated by the insulating separation wall 12 having the thickness of 3 $\mu$m.

The magnetic wire 2 is made of a CoFeSiB amorphous alloy and has the diameter of 5 $\mu$m. The periphery of the magnetic wire 2 is coated with an insulating glass. The length is 0. 40 mm.

The anisotropic magnetic field of the magnetic wire 2 is 15 G, and has a two-phase magnetic domain structure of a surface magnetic domain having spin alignment in a circumferential direction, and a central core magnetic domain having spin alignment in an axial direction.

The number of turns of the coil 3 is 100, and the coil pitch of the coil 3 is 3 $\mu$m. The interval between the coil 3 and the magnetic wire 2 is 2 $\mu$m, and the average inner diameter of the coil is 8 $\mu$m.

The substrate film 10b having the thickness of 7 $\mu$m is formed on the insulating protective film 10a of the upper surface of the ASIC, and the groove having the depth of 3 $\mu$m is attached thereto to form the element 1.

The capacitance of the capacitor 57 of the electronic circuit 5 is 6 pF. The reduced frequency of the pulse current is 0.4 GHz, the intensity of the pulse current is 50 mA, and the pulse time is 1 nsec. The timing of the peak voltage of the rising pulse is detected. The electronic switch includes on-off, and the opening and closing is repeated for every 0.1 nsec. The AD conversion of the electronic circuit 5 is performed by 16 bits.

The coil output is in the measurement range of 3 G, and the sensitivity thereof is 1000 mV/G The linearity is equal to or less than 0.3%.

Industrial Applicability

In the present invention, an element and an ASIC are integrated to achieve the ultra-small size of a GSR sensor, and the present invention is expected to be used in application in which the ultra-small size and high performance are required such as an in-vivo motion device.

The present invention is applicable to a small size and ultra-high sensitivity GSR sensor for an automobile, a wearable computer, or the like.

Reference Signs List

   1: GSR sensor element
   10a: Insulating protective film a, 10b: Substrate film b, 11: Groove, 12: Insulating separation wall, 13: Insulating resin, 14: Element thickness
   2: Magnetic wire
   21: One of pair of magnetic wire, 22 Another one of pair of magnetic wire, 23: Wire coupling part, 24: Wire input electrode (+), 25: Wire output electrode (-), 26: Wire electrode connection part (+), 27: Wire electrode connection part (-)
   3: Coil
   31: Lower coil, 32: Upper coil, 33: Joint part, 34: Coil output electrode (+), 35: Coil ground electrode (-)
   4: ASIC
   40: ASIC thickness, 41: ASIC side wire electrode (+), 42: ASIC side wire electrode (-), 43: Through hole type electrode joint part (+), 44: Through hole type electrode joint part (-), 45: External wiring electrode, 46: External wiring earth electrode, 47: External wiring
   5: Electronic circuit
   51: Pulse transmitting circuit (pulse transmitter), 52: Element, 53: Input circuit, 54: Buffer circuit, 55: Sample hold circuit, 56: Electronic switch, 57: Capacitor, 58: Amplifier

**Claims**

1.  An ultra-small and high-sensitivity magnetic sensor comprising: an application specific integrated circuit ASIC (4); an insulating protective film (10a) formed on a wiring plain surface of the ASIC (4); a substrate film (10b) having a groove (11); and a magnetic field detection element (1),

    wherein the magnetic field detection element (1) comprises
    two conductive magnetic wires (21, 22) arranged adjacent and parallel to one another, and fixed in the groove (11),
    a wire coupling part (23) connecting a lower end of one magnetic wire (21) and a lower end of the other magnetic wire (22) of the two conductive magnetic wires (21, 22);
    two electrodes (24, 25) for wire energization, connection parts (26, 27) between the two conductive magnetic wires (21, 22) and the electrodes (24, 25) for wire energization,
    a detection coil (3) wound around the two conductive magnetic wires (21, 22),
    two electrodes (34, 35) for coil voltage detection, a connection part between the coil (3) and the two electrodes (34, 35) for coil voltage detection, wherein

the two conductive magnetic wires (21, 22) have conductivity and an anisotropic magnetic field of 20 G or smaller, and have a two-phase magnetic domain structure of a surface magnetic domain having spin alignment in a circumferential direction, and a central core magnetic domain having spin alignment in an axial direction, and are fixed and covered by an insulating resin (13), and

the detection coil (3) has a coil pitch of 10 μm or smaller, **characterized in that**,

the substrate film (10b) is formed on the insulating protective film (10a),

the electrodes (24, 25) for wire energization are directly jointed to an element coupling electrode of the ASIC (4) passing through the substrate film (10b) and the insulating protective film (10a), and

in the magnetic field detection element (1),

a lower part (31) of the detection coil (3) is formed along the groove surface of the groove (11) and both sides of the groove (11) formed on the substrate film (10b),

an upper part (32) of the detection coil (3) is provided on the insulating resin (13),

the detection coil (3) is wound around the two conductive magnetic wires (21, 22), and

an insulating separation wall (12) is arranged between the two conductive magnetic wires (21, 22).

2. The ultra-small and high-sensitivity magnetic sensor in accordance with claim 1,

wherein the ASIC (4) comprises a means that causes a pulse current of a reduced frequency of 0.2 GHz to 4.0 GHz to flow in the two conductive magnetic wires (21, 22) of the magnetic field detection element (1), a means that detects a coil voltage generated in the detection coil (3) when the pulse current flows in the two conductive magnetic wires (21, 22), and a means that converts the coil voltage into an electric signal proportional to an external magnetic field H.

3. The ultra-small and high-sensitivity magnetic sensor in accordance with claim 1,

wherein the substrate film (10b) has a thickness of 1 μm to 20 μm.

4. The ultra-small and high-sensitivity magnetic sensor in accordance with any one of claims 1 to 3,

wherein in the magnetic field detection element (1), the groove (11) of a depth of 1 μm to 10 μm from an upper surface of the substrate skin is arranged, and a part or all of the detection coil (3) is embedded.

**Patentansprüche**

1. Ultrakleiner und hochempfindlicher Magnetsensor, umfassend: eine anwendungsspezifische integrierte Schaltung ASIC (4); einen isolierenden Schutzfilm (10a), der auf einer Verdrahtungsebene des ASIC (4) ausgebildet ist; einen Substratfilm (10b) mit einer Rille (11); und ein Magnetfelddetektionselement (1), wobei das Magnetfelddetektionselement (1) umfasst:

zwei leitende Magnetdrähte (21, 22), die nebeneinander und parallel zueinander angeordnet und in der Rille (11) befestigt sind,

ein Drahtkopplungsteil (23), das ein unteres Ende des einen Magnetdrahtes (21) und ein unteres Ende des anderen Magnetdrahtes (22) der zwei leitenden Magnetdrähte (21, 22) verbindet,

zwei Elektroden (24, 25) zur Drahtenergiespeisung,

Verbindungsteile (26, 27) zwischen den zwei leitenden Magnetdrähten (21, 22) und den Elektroden (24, 25) zur Drahtenergiespeisung,

eine Detektionsspule (3), die um die zwei leitenden Magnetdrähte (21, 22) gewickelt ist,

zwei Elektroden (34, 35) zur Erfassung der Spulenspannung,

ein Verbindungsteil zwischen der Spule (3) und den zwei Elektroden (34, 35) zur Erfassung der Spulenspannung, wobei

die zwei leitenden Magnetdrähte (21, 22) eine Leitfähigkeit und ein anisotropes Magnetfeld von 20 G oder weniger aufweisen und eine zweiphasige magnetische Domänenstruktur aus einer Oberflächenmagnetdomäne mit Umfangsspinausrichtung und einer zentralen Kernmagnetdomäne mit Spinausrichtung in einer axialen Richtung aufweisen und durch ein isolierendes Harz (13) fixiert und abgedeckt sind, und

die Detektionsspule (3) einen Spulenabstand von 10 μm oder weniger aufweist, **dadurch gekennzeichnet, dass**,

der Substratfilm (10b) auf dem isolierenden Schutzfilm (10a) ausgebildet ist,

die Elektroden (24, 25) zur Drahtenergiespeisung direkt mit einer Elementkopplungselektrode des ASIC (4) verbunden sind, die durch den Substratfilm (10b) und den isolierenden Schutzfilm (10a) hindurchgeht, und

in dem Magnetfelddetektionselement (1),

ein unterer Teil (31) der Detektionsspule (3) entlang der Rillenoberfläche der Rille (11) und beider Seiten der Rille (11), die auf dem Substratfilm (10b) ausgebildet ist, ausgebildet ist,

ein oberer Teil (32) der Detektionsspule (3) auf dem isolierenden Harz (13) vorgesehen ist,

die Detektionsspule (3) um die zwei leitenden Magnetdrähte (21, 22) gewickelt ist, und

eine isolierende Trennwand (12) zwischen den zwei leitenden Magnetdrähten (21, 22) angeordnet ist.

**2.** Ultrakleiner und hochempfindlicher Magnetsensor nach Anspruch 1,
wobei der ASIC (4) ein Mittel umfasst, das einen Pulsstrom einer reduzierten Frequenz von 0,2 GHz bis 4,0 GHz in den zwei leitenden Magnetdrähten (21, 22) des Magnetfelddetektionselements (1) fließen lässt, ein Mittel, das eine in der Detektionsspule (3) erzeugte Spulenspannung detektiert, wenn der Pulsstrom in den zwei leitenden Magnetdrähten (21, 22) fließt, und ein Mittel, das die Spulenspannung in ein elektrisches Signal umwandelt, das proportional zu einem externen Magnetfeld H ist.

**3.** Ultrakleiner und hochempfindlicher Magnetsensor nach Anspruch 1,
wobei der Substratfilm (10b) eine Dicke von 1 μm bis 20 μm hat.

**4.** Ultrakleiner und hochempfindlicher Magnetsensor nach einem der Ansprüche 1 bis 3,
wobei in dem Magnetfelddetektionselement (1) die Rille (11) mit einer Tiefe von 1 μm bis 10 μm von einer oberen Oberfläche der Substrathaut angeordnet ist, und ein Teil oder die gesamte Detektionsspule (3) eingebettet ist.

**Revendications**

**1.** Capteur magnétique très petit et de grande sensibilité comprenant : un circuit intégré spécifique à l'application ASIC (4) ; un film protecteur isolant (10a) formé sur une surface plane de câblage de l'ASIC (4) ; un film de substrat (10b) comportant une rainure (11) ; et un élément de détection de champ magnétique (1),

dans lequel l'élément de détection de champ magnétique (1) comprend
deux fils magnétiques conducteurs (21, 22) agencés adjacents et parallèles l'un à l'autre, et fixés dans la rainure (11),
une partie de couplage de fil (23) reliant une extrémité inférieure d'un film magnétique (21) et une extrémité inférieure de l'autre film magnétique (22) parmi les deux fils magnétiques conducteurs (21, 22) ;
deux électrodes (24, 25) pour l'excitation des fils,
des parties de connexion (26, 27) entre les deux fils magnétiques conducteurs (21, 22) et les électrodes (24, 25) pour l'excitation des fils,
une bobine de détection (3) enroulée autour des deux fils magnétiques conducteurs (21, 22),

deux électrodes (34, 35) pour une détection de tension de bobine, une partie de connexion entre la bobine (3) et les deux électrodes (34, 35) pour une détection de tension de bobine, dans lequel
les deux fils magnétiques conducteurs (21, 22) présentent une conductivité et un champ magnétique anisotrope de 20 G ou moins, et présentent une structure de domaine magnétique biphasé d'un domaine magnétique de surface présentant un alignement de rotation dans une direction circonférentielle, et un domaine magnétique de noyau central présentant un alignement de rotation dans une direction axiale et sont fixés et recouverts par une résine isolante (13), et
la bobine de détection (3) comporte un pas de bobine de 10 μm ou moins, **caractérisé en ce que**,
le film de substrat (10b) est formé sur le film protecteur isolant (10a),
les électrodes (24, 25) pour une excitation des fils sont directement joints à une électrode de couplage d'élément de l'ASIC (4) passant à travers le film de substrat (10b) et le film protecteur isolant (10a), et
dans l'élément de détection de champ magnétique (1),
une partie inférieure (31) de la bobine de détection (3) est formée le long de la surface de rainure de la rainure (11) et des deux côtés de la rainure (11) formée sur le film de substrat (10b),
une partie supérieure (32) de la bobine de détection (3) est fournie sur la résine isolante (13),
la bobine de détection (3) est enroulée autour des deux fils magnétiques conducteurs (21, 22), et
une paroi de séparation isolante (12) est agencée entre les deux fils magnétiques conducteurs (21, 22).

**2.** Capteur magnétique très petit et de grande sensibilité selon la revendication 1,
dans lequel l'ASIC (4) comprend un moyen qui amène un courant d'impulsion d'une fréquence réduite de 0,2 GHz à 4,0 GHz à s'écouler dans les deux films magnétiques conducteurs (21, 22) de l'élément de détection de champ magnétique (1), un moyen qui détecte une tension de bobine générée dans la bobine de détection (3) lorsque le courant d'impulsion s'écoule dans les deux films magnétiques conducteurs (21, 22), et un moyen qui convertit la tension de bobine en un signal électrique proportionnel à un champ magnétique externe H.

**3.** Capteur magnétique très petit et de grande sensibilité selon la revendication 1,
dans lequel le film de substrat (10b) présente une

épaisseur de 1 μm à 20 μm.

4. Capteur magnétique très petit et de grande sensibilité selon l'une quelconque des revendications 1 à 3, dans lequel, dans l'élément de détection de champ magnétique (1), la rainure (11) d'une profondeur de 1 μm à 10 μm à partir d'une surface supérieure de la peau de substrat est agencée, et une partie ou l'intégralité de la bobine de détection (3) est encastrée.

EP 3 657 192 B1

Fig. 1

Fig. 2

Fig. 3

EP 3 657 192 B1

Fig. 4

Fig. 5

PULSE CURRENT

0.5nsec 0.5nsec 0.5nsec

t

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 583975 A
- JP 2015134166 A
- JP 2017012840 A
- JP 2014153309 A
- JP 2014042055 A
- US 20160238673 A1
- US 20140247042 A1